# EUROPEAN PATENT SPECIFICATION

(11) **EP 0 661 783 B1**
(45) Date of publication and mention of the grant of the patent: **15.07.1998**
(21) Application number: 94120765.6
(22) Date of filing: 27.12.1994
(51) Int. Cl.: H01S 3/19, H01L 33/00, H01S 3/025, H01S 3/103, H01L 21/20, H01L 27/14

(54) **Method for fabricating semiconductor light integrated circuit**
Verfahren zur Herstellung eines integrierten, optischen Halbleiterschaltkreises
Méthode pour la fabrication d'un circuit optique intégré à semi-conducteur

(30) Priority: 28.12.1993 JP 334641/93
(43) Date of publication of application: 05.07.1995
(73) Proprietor: NEC CORPORATION, Tokyo (JP)
(72) Inventor: Kato, Tomoaki, c/o NEC Corporation, Tokyo (JP)
(74) Representative: Glawe, Delfs, Moll & Partner

(56) References cited:
- EP-A- 0 525 779
- EP-A- 0 558 089
- WO-A-93/22793
- PROCEEDINGS OF THE 4TH INTERNATIONAL CONFERENCE ON INDIUM PHOSPHIDE AND RELATED MATERIALS, 21 April 1992, NEWPORT, US pages 202 - 205 G.COUDENYS ET AL. 'Lateral Bandgap Engineering for InP-Based Photonic Integrated Circuit'
- ELECTRONICS AND COMMUNICATIONS IN JAPAN, PART II: ELECTRONICS, vol.76, no.4, April 1993, NEW YORK, US pages 1 - 11, XP420772 T.SASAKI ET AL. 'Selective MOVPE Growth and Its Application to Semiconductor Photonic Integrated Circuits'
- PATENT ABSTRACTS OF JAPAN vol. 16, no. 336 (E-1237) 21 July 1992 & JP-A-04 100 291 (FUJITSU) 2 April 1992

## Description

The invention relates to a method for fabricating a semiconductor light integrated circuit, especially to an improved method of an MOVPE (Metalorganic Vapor Phase Epitaxy) for performing epitaxial growth.

Recently, in semiconductor fabrication technology, growth preventing masks are arranged on both sides of a stripe-shaped aperture, and a semiconductor layer is selectively epitaxial-grown on the aperture by MOVPE (Metalorganic Vapor Phase Epitaxy), which is called selective MOVPE. By this technology, a light waveguide device can be formed without etching technique, therefore the fabrication can be simplified and the yield gets better. When the selective MOVPE technology is applied to epitaxial growth of a quantum well structure of the III-V family of compound semiconductor, diffusion of growth raw material (mainly III family of organic metal material) in vapor depends on the width of the mask by which the solid phase composition of the raw material varies, and the growth speed depends on the width of the mask by which the width of the quantum well structure layer varies. Based on the synergistic effect of the above mentioned theory, bandgap energy (transmission energy in the first energy level between valence electron band and conduction band) on the same substrate can be changed by a single MOVPE growth process using a mask with different width partially. This kind of technology is good for fabrication of a light integrated circuit which is required for monolithic integration of optical function devices having different bandgap energy. The inventor has proposed an integrated light source and a tunable DBR laser each of which is fabricated by monolithic integration of a field absorbent type of optical modulator and a distributed feedback laser.

Each the variation of solid phase composition and the thickness of the grown layer in response to the difference of width of the mask makes the same amount of bandgap variation, although they can be adjusted by changing growth condition. This means that the thickness of the selective growth layer varies when the mask is changed in width for control of bandgap energy, even if a user does not want to.

Practically, such a quantum well structure layer is sandwiched with doped clad layers, and current is injected or electric field is applied to the well structure for providing optical function with the well layer. In this processing, electric characteristics, such as device resistance and reverse proof voltage, are changing in response to the width variation of the mask, and therefore, important parameters for reliability of the optical functional device can be changed. If the width of layers are much different on the substrate, that may cause the quality of photolithography processing to be worse.

EP-A-0558089 discloses a method for fabricating a light integrated circuit by a selective growth technique. An aperture is defined on a semiconductor substrate by a growth prevention mask which surrounds the aperture. The growth prevention mask has different width in the longitudinal direction in order to control the band gap energy. On the exposed substrate surface within the aperture region there are grown in succession a waveguide layer, a quantum well structure and a cladding layer. The growth takes place at a pressure between 2666 and 26664 Pascal (20 and 200 Torr). The active layer is deposited at 5332 Pascal (40 Torr).

WO-A-93/22793 on the other hand discloses a method of fabricating a plurality of optoelectronic components on a semiconductor substrate, each optoelectronic component comprising several layers grown in a reactor. Every layer is being grown under a predetermined individual pressure. The active layers of all components are laying substantially at the same high. Control of the pressure in the reactor allows the thickness of the layer grown to be constant or to vary over a substrate area.

Furthermore, "Electronics and Communications in Japan", part 2, vol. 76, no. 4, April 1993, pages 1 - 11 discloses a bandgap energy-controlling technique of quantum well structures using a selective Metaloxide Vapor Phase Epitaxial (MOVPE) growth, which is a better fabrication technique. As an application example, an integrated light source was fabricated by integrating a tuneable laser, distributed feedback (DSB) laser, and a semiconductor optical modulator. Than the tuneable characteristics and the extinction characteristics were verfied. This simplifies the fabrication method of the previously difficult method of semiconductor photonic integrated circuit and clarifies the possibility of developing a high density integrated element.

Accordingly, an object of the invention is to provide an improved method for fabricating a semiconductor light integrated circuit by which stable electric characteristics can be provided.

Another object of the invention is to provide an improved method for fabricating a semiconductor light integrated circuit by which photolithography processing can be carried out precisely.

According to the present invention this object is achieved by a method according to claim 1. The further claims are related to different advantageous developments of the present invention.

In a method for fabricating a semiconductor light integrated circuit according to the invention, a light waveguide layer and a clad layer are provided on a longitudinal aperture by epitaxial growth technique using a relatively low growth pressure. In contrast with those layers, a quantum well structure layer is selectively provided on the longitudinal aperture by epitaxial growth technique using a relatively high growth pressure.

That is, the method for fabricating a semiconductor light integrated circuit, according to the invention, includes the following steps:
(a) providing a longitudinal aperture on a semiconductor substrate;
(b) providing a mask layer surrounding the longitudinal aperture on the semiconductor substrate so as to have different widths in the longitudinal direction to control bandgap energy;
(c) selectively providing a light waveguide layer on the longitudinal aperture by epitaxial growth technique using a relatively low growth pressure;
(d) selectively providing a quantum well structure layer on the longitudinal aperture by epitaxial growth technique using a relatively high growth pressure; and
(e) selectively providing a clad layer on the longitudinal aperture by epitaxial growth technique using a relatively low growth pressure.

Fig. 1 is a cross-sectional view showing the structure of a semiconductor light integrated circuit, used for explaining a theory based on which the invention is made.

Fig. 2 is a graph showing the relationship between mask width and thickness of layers in the integrated circuit, used for explaining a theory based on which the invention is made.

Fig. 3 is a plan view illustrating a semiconductor light integrated circuit fabricated by a method of a first preferred embodiment according to the invention.

Figs. 4A to 4C are cross-sectional views illustrating fabrication steps of the first preferred embodiment.

Fig. 5 is a plan view illustrating a semiconductor light integrated circuit fabricated by a method of a second preferred embodiment according to the invention.

Figs. 6A to 6C are cross-sectional views illustrating fabrication steps of the second preferred embodiment.

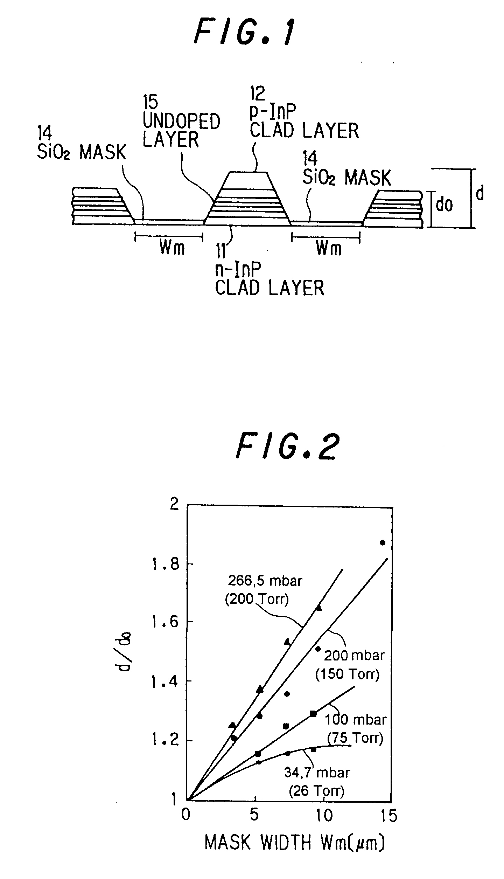

First of all, the theory of the invention is now explained. Fig. 1 shows a light integrated circuit which includes clad layers 11 and 12, a mask layer 14 having a width of Wm and an undoped layer 15. The invention is based on the theory that dependency of the thickness of the selective growth layers (11, 12 and 15) and bandgap energy on the width of the mask layer 14 are changed in response to variation of growth pressure of the selective growth layers (11, 12 and 15). That is, the quantum well structure layer (15), required to have great variation of bandgap energy, is selectively grown with a relatively high growth pressure to develop the dependency of bandgap energy on the width of the mask 14. The clad layers 11 and 12, not required to have great variation of bandgap energy, are selectively grown with a relatively low growth pressure to restrain the increase of the thickness of the selective growth layers (11, 12 and 15). That can be called "dynamic pressure control type of selective MOVPE technology".

Generally, it has been understood that variation ΔE of bandgap energy relative to variation of the width of the mask is changed in response to variation of growth pressure in the selective MOVPE growth processing, because the balance between consumption, diffusion and re-separation of raw material is changed in response to variation of the growth pressure. In more detail, when flowing speed of raw material gas is lowered by increasing the growth pressure, the concentration gradient in the phase is developed, and therefore, diffusion of the mask in a side direction is increased and variation ΔE of bandgap energy relative to variation of the width of the mask is changed dramatically. At the same time, the amount of the raw material re-separated from the mask is restrained, so that more amount of raw material is supplied to the selective growth layers.

According to the invention, non of the advantages of the selective MOVPE growth technique, shown as follows, is lost:
(a) No wet-etching of a semiconductor layer is required, so that the yield and stability are well.
(b) No useless absorbent loss is provided, because no dummy layer is required for dry-etching of a conductive layer.
(c) There is no diffusion loss because a light waveguide is naturally formed to have a very flat surface in growth processing.
(d) There is no reflection at a joint portion of light waveguides formed by alternative growth processing.

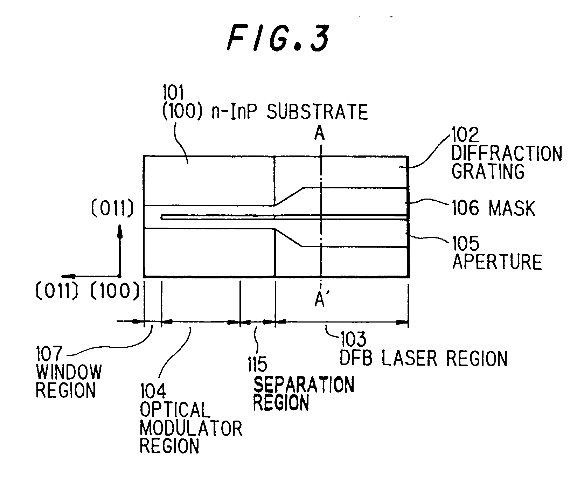

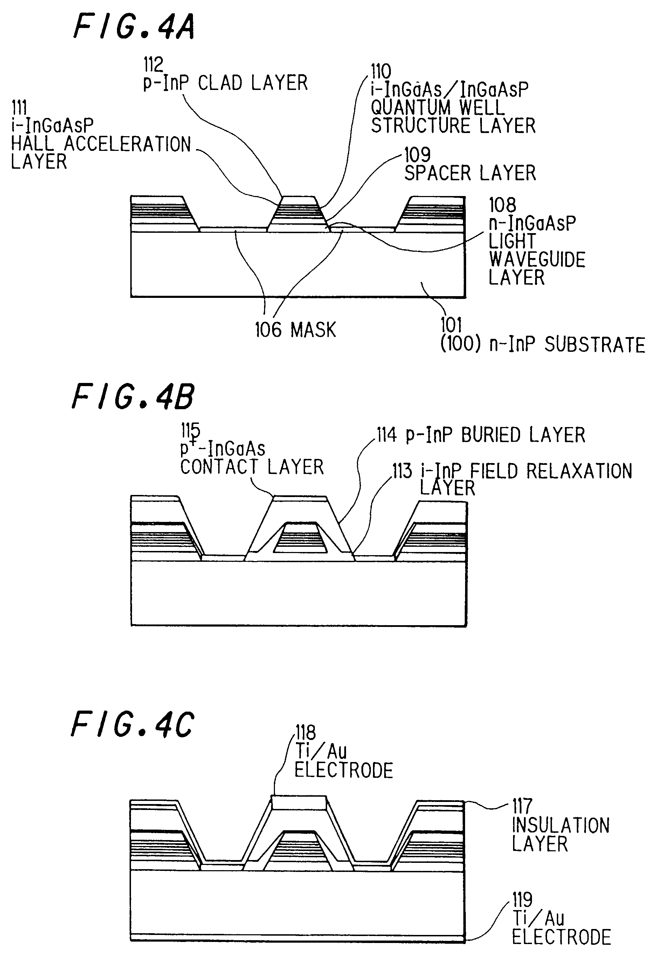

Next, first and second preferred embodiments of the invention are described. Fig. 3 shows an integrated light source, fabricated by monolithic integration of a field absorbent type of light modulator and a DFB laser, according to the first preferred embodiment. Figs. 4A to 4C show the fabrication steps of the integrated light source shown in Fig. 3.

In fabrication, a diffraction grating 102 is partially formed on an n-InP substrate 101, having a [100] surface direction, to have a cycle of 240nm in a [011] direction and a depth of 30nm. The area on which the diffraction grating 102 is formed is used as a DFB laser region 103, and the other regions is used as an optical modulator region 104. An SiO₂ layer is formed on the substrate by heat CVD technique, and then a stripe-shaped aperture 105 is formed to have a width of 2µm by photolithography and etching technique. Then, a growth preventing mask 106 is formed on the both sides of the aperture 105 to have a width of 17µm on the DFB laser region 103 and of 8µm on the optical modulator region 104. The mask 106 extends in parallel to [011] direction of the n-InP substrate 101. A window region 107 is formed on the substrate at an area located at 15µm from an end of the optical modulator region 107 by forming no aperture thereat, as shown in Fig. 3.

Subsequently, as shown in Fig. 4A, by using a depressurization MOVPE apparatus, an n-InGaAsP light waveguide layer 108 having a wavelength composition of 1.15µm and a thickness of 100nm, an n-InP spacer layer 109 having a thickness of 40nm, an undoped quantum well layer 110 of 7 cycles composed of an undoped InGaAsP barrier layer having a wavelength composition of 1.3µm and a thickness of 10nm and an undoped InGaAs well layer having a thickness of 7nm, an undoped InGaAsP hole acceleration layer 111 having a wavelength composition of 1.15µm and a thickness of 40nm, and a p-InP clad layer 112 having a thickness of 200nm are continuously MOVPE-grown on the aperture 105. In this growth processing, the n-InGaAsP light waveguide layer 108, n-InP spacer layer 109, undoped InGaAsP hole acceleration layer 111 and p-InP clad layer 112 are grown at a pressure of 33 mbar (25 Torr), but the undoped quantum well layer 110 is grown at a pressure of 200 mbar (150 Torr). The growth condition is controlled so as to the undoped InGaAs well layer and the undoped InGaAsP barrier layer are lattice-matched with the n-InP substrate 101 on the DFB laser region 103. The undoped quantum well region 110 has bandgap wavelengths of 1.55µm and 1.48µm on the DFB laser region 103 and the optical modulator region 104, respectively.

Next, as shown in Fig. 4B, the aperture 105 is expanded in width to 7µm and 5µm on the DFB laser region 103 and the optical modulator region 104, respectively, by photolithography and etching processing. On the expanded aperture 105, an undoped InP field relaxation layer 113 having a thickness of 40nm, a p-InP buried layer 114 having a thickness of 1.4µm and a p+ InGaAs contact layer 115 having a thickness of 200nm are selectively grown by MOVPE technique. In order to electrically separate the DFB laser region 103 and optical modulator region 104 from each other, the p+ InGaAs contact layer 115 is partially removed 25µm from the boundary thereof to the optical modulator region to form a separation layer 116, shown in Fig. 3.

Next, as shown in Fig. 4C, an insulation layer 117 is provided over the entire structure to have a thickness of 0.3µm, then holes are shaped in the insulation layer 117 at tops where the p+ InGaAs contact layer is remaining by photolithography and etching technique. A Ti/Au electrode 118 is evaporated and patterned by photolithography and etching technique. The n-InP substrate 101 is ground to 100µm, and then a Ti/Au electrode 119 is evaporated on the rear surface thereof.

Consequently, a low reflection layer and a high reflection layer are provided on the ends of the optical modulator region and the DFB laser region, respectively. In this embodiment, each thickness of layer represents a thickness of a layer selectively grown on the aperture in the DFB laser region.

In thus fabricated integrated light source, when current is injected into the DFB laser region 103, single mode oscillation is performed with a wavelength which is determined by an effective refraction rate, which is calculated based on the pitch of the diffraction grating 102 and the cross-sectional structure thereof. The undoped quantum well layer 110 (light absorbent layer) in the optical modulator region 104 has a bandgap energy of 1.48µm in order to restrain light absorption in non bias condition. When field is applied to the light absorbent layer, absorption coefficient relative to transmission light is increased by QCSE (Quantum-Confined Stark Effect), so that the structure can operate as a light strength modulator.

When 3V reverse voltage is applied to the optical modulator region 103, the light absorbent layer is biased by high field of 200kV/cm, and therefore, light absorption coefficient relative to 1.55µm oscillation wavelength is increased by 4300cm⁻¹ by QCSE. A light confine coefficient of the seven layered well layer is 4%, so that 15dB of extinction ratio is obtained with 200µm of device length.

Generally, when a light is reflected at the output end of the optical modulator region, the light is reflected back and forth in the optical modulator region 104 and fedback to the DFB laser region 103. If this kind of remaining reflection light is changed in dynamic in light strength modulation, the waveform of light signal, which has been transmitted in an optical fiber in a long distance communication, is degraded by chirping phenomena in which oscillation wavelength is changed in the modulation processing. In order to avoid this kind of problem, less than 0.1% of reflection rate is required at the end of the optical modulator region, however, it is generally difficult to obtain the reflection rate. According to the invention, the window region 107 providing no light confine in vertical direction is provided, so that a light supplied thereto is spread and led to the end of the optical modulator region 104. Only a light reached in 90 degree angle to the end surface can be reflected to the optical modulator region 104, so that 0.1 % of reflection rate can be easily realized with a low reflection layer.

In the above mentioned embodiment, the DFB laser region 103 provides single mode oscillation at 1.55µm of oscillation wavelength and 10mA of threshold current value. This means that the coupling efficiency between the DFB laser region 104 and the optical modulator region 104 is 100% and the optical modulator region 104 supplies 10mW of output power. The resistance between the DFB laser region 103 and the optical modulator laser 104 is 10kΩ, which makes good electrical separation with no problem in practical use. When a 80km communication was tested in 2.5Gb/s band with the invented integrated light source, wavelength charping phenomena is restrained sufficiently, and therefore, high quality transmission could be realized.

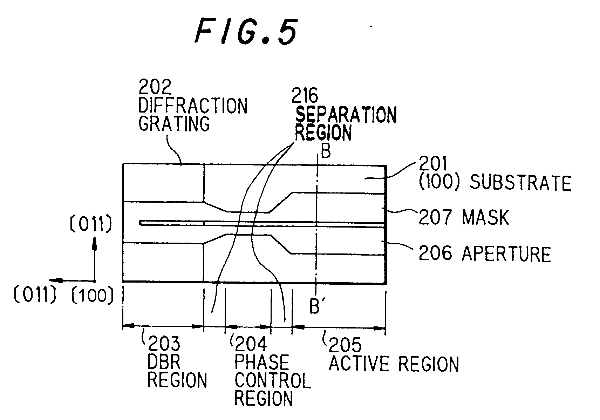

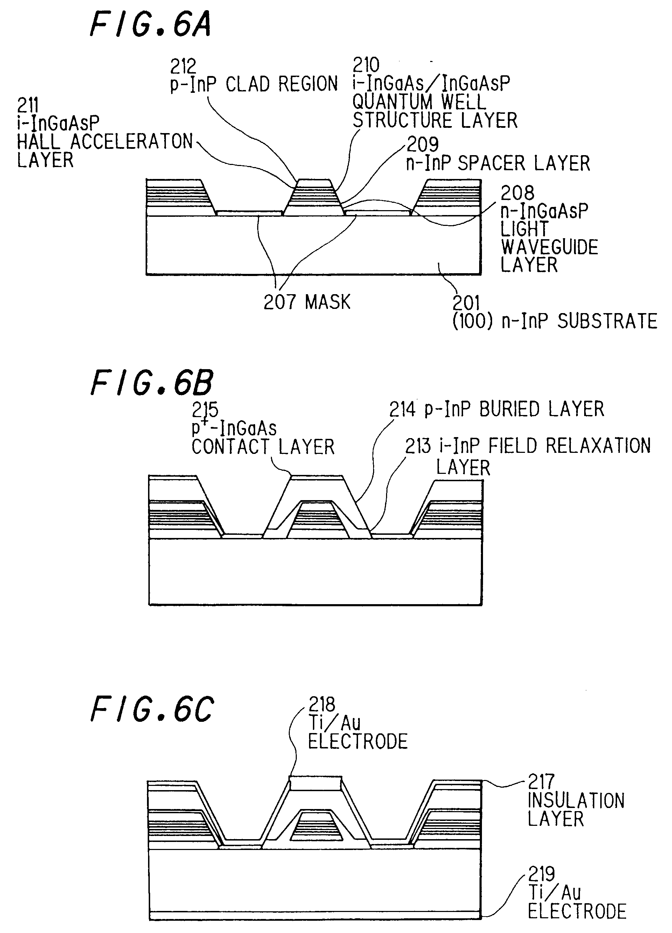

Next, a second preferred embodiment according to the invention is now described in conjunction with Figs. 5 and 6A to 6C. This embodiment is on a variable wavelength type of DBR laser. In fabrication, a diffraction grating 202 is partially formed on an n-InP substrate 201 of a [100] surface direction, to have a cycle of 240nm in a [011] direction and a depth of 30nm. The area on which the diffraction grating 202 is formed is used as a DBR, and one half of the other area closer to the DBR region is used as a phase control region 204 and the other half is used as an active region 205. An SiO₂ layer is formed on the substrate by heat CVD technique, and then a stripe-shaped aperture 206 is formed to have a width of 2µm by photolithography and etching technique. Then, a growth preventing mask 207 is formed on the both sides of the aperture 206 to have a width of 12µm on the DBR laser region 203, of 8µm on the phase control region 204 and of 17µm on the active region 205. The mask 207 extends in parallel to [011] direction of the n-InP substrate 201, as shown in Fig. 5.

Subsequently, as shown in Fig. 6A, by using a depressurization MOVPE apparatus, an n-InGaAsP light waveguide layer 208 having a wavelength composition of 1.15µm and a thickness of 100nm, an n-InP spacer layer 209 having a thickness of 40nm, an undoped quantum well layer 210 of 7 cycles composed of an undoped InGaAsP barrier layer having a wavelength composition of 1.3µm and a thickness of 10nm and an undoped InGaAs well layer having a thickness of 7nm, an undoped InGaAsP hole acceleration layer 211 having a wavelength composition of 1.15µm and a thickness of 40nm, and a p-InP clad layer 212 having a thickness of 200nm are continuously MOVPE-grown on the aperture 206. In this growth processing, the n-InGaAsP light waveguide layer 208, n-InP spacer layer 209, undoped InGaAsP hole acceleration layer 211 and p-InP clad layer 212 are grown at a pressure of 33 mbar (25 Torr), but the undoped quantum well layer 210 is grown at a pressure of 200 mbar (150 Torr). The growth condition is controlled so as to the undoped InGaAs well layer and the undoped InGaAsP barrier layer are lattice-matched with the n-InP substrate 201 on the active region 205. The undoped quantum well region 210 has bandgap wavelengths of 1.51µm, 1.48µm and 1.55µm on the DBR region 203, the phase control region 204 and the active region 205, respectively.

Next, as shown in Fig. 6B, the mask 207 is continuously etched from the inside thereof for each 2µm to expand the aperture 206. On the expanded aperture 206, an undoped InP spacer layer 213 having a thickness of 40nm, a p-InP buried layer 214 having a thickness of 1.4µm and a p+ InGaAs contact layer 215 having a thickness of 200nm are selectively grown by MOVPE technique. In order to electrically separate those regions from each other, the p+ InGaAs contact layer 215 is partially removed 25µm from the boundary portions of those regions to form a separation layer 216, shown in Fig. 5.

Next, as shown in Fig. 4C, an insulation layer 217 is provided over the entire structure to have a thickness of 0.3µm, then holes are shaped in the insulation layer 217 at tops where the p+ InGaAs contact layer is remaining by photolithography and etching technique. A Ti/Au electrode 219 is evaporated and patterned by photolithography and etching technique. The n-InP substrate 101 is ground to 100µm, and then a Ti/Au electrode 219 is evaporated on the rear surface thereof.

Consequently, a low reflection layer and a high reflection layer are provided on the ends of the DBR region and active region, respectively. In this embodiment, each thickness of layer represents a thickness of a layer selectively grown on the aperture in the DFB laser region.

In thus fabricated tunable DBR laser, when current is injected into the active region 205, single mode oscillation is performed with a wavelength which is determined by an effective refraction rate, which is calculated based on the pitch of the diffraction grating 202 and the cross-sectional structure of the DBR region 203. When current is supplied into the DBR region 203, the oscillation wavelength changes forwarding to the shortwave side in descrete fashion in accordance with alternative axis mode jumping with reduction of the refraction rate by plasma diffusion effect. When phase matching condition of light transmitting back and forth in the oscillator is controlled by adjusting current to be supplied to the phase control region 204, oscillation can be realized even within oscillation wavelength which has changed in descrete fashion, and therefore, virtual continuous turning operation of oscillation wavelength can be realized.

In the tunable DBR laser, when 15mA of current is supplied into the active region 205, a single axis mode oscillation is performed and generate 15mW of maximum light output. When 60mA of current is supplied into the DBR region 203, 7nm of maximum wavelength width is generated. At the same time, current is supplied into the phase control region 204, virtual continuous turning operation of oscillation wavelength can be realized.

## Claims

1. A method for fabricating a semiconductor light integrated circuit, comprising the steps of:
providing a growth preventing mask (14) on a semiconductor substrate (101), said growth preventing mask being shaped with a first portion of a first width and a second portion of a second width wider than said first width, said first and second portions having a non-masking stripe aperture of constant width extending longitudinally through said second portion into said first portion such that between the end of the aperture in the first portion and the edge at the longitudinal end of the first portion an area is formed which serves as a window region of the semiconductor light integrated circuit, and whereby the different widths of said first and second portions serve to control the bandgap energy of semiconductor layers to be grown on the aperture; selectively growing a light waveguide layer (108, 208) on said non-masking stripe aperture of said semiconductor substrate by an epitaxial growth technique using a low growth pressure of 33 mbar (25 Torr);
increasing the growth pressure above said low growth pressure to 200 mbar (150 Torr);
selectively growing a multiple quantum well structure layer (15, 100, 210) on said light waveguide layer by said epitaxial growth technique;
decreasing said growth pressure below said high growth pressure to 33 mbar (25 Torr);
selectively growing a clad layer (12, 112, 212) on said multiple quantum well structure layer (15, 110, 210) by said epitaxial growth technique;
wherein said light waveguide-layer growing step, said growth pressure-increasing step, said multiple quantum well structure layer-growing step, said growth pressure-decreasing step, and said clad layer-growing step are successively carried out in one Metalorganic Vapor Phase Epitaxy process.

2. The method according to claim 1, further comprising the step of:
providing an electrode structure (118, 119) for injecting current or applying voltage to said multiple quantum well structure layer.

3. The method according to claim 1, further comprising the step of:
providing an optical modulator region (104) in which a low reflection layer is formed on its facet, the facet of the opitcal modulator region being provided with a window region (107) in which no optical waveguide structure is formed so as to spread a light launched from the optical waveguide stucture to the low reflection layer.

4. The method according to claim 1, wherein:
said semiconductor light integrated circuit is an integrated light source including an field absorbent type of optical modulator and a Distributed Feedback laser which are integrated in a monolithic fashion.

5. The method according to claim 1, wherein:
said semiconductor photonic integrated circuit is a tunable Distributed Bragg Reflection laser.

## Patentansprüche

1. Verfahren zur Herstellung einer integrierten optischen Halbleiterschaltung mit den Schritten:
Ausbilden einer Wachstumsverhinderungsmaske (14) auf einem Halbleitersubstrat (101), wobei die Wachstumsverhinderungsmaske mit einem ersten Abschnitt einer ersten Breite und einem zweiten Abschnitt einer zweiten Breite - größer als die erste Breite - ausgeformt ist, wobei der erste und zweite Abschnitt eine Nicht-Maskierungs-Streifenöffnung mit konstanter Breite haben, die sich longitudinal durch den zweiten Abschnitt in den ersten Abschnitt erstreckt, so daß in dem ersten Abschnitt zwischen dem Ende der Öffnung und der Kante am Längsende des ersten Abschnitts ein Gebiet ausgebildet ist, der als Fensterbereich der integrierten optischen Halbleiterschaltung dient, und wobei die verschiedenen Breiten der ersten und zweiten Abschnitte zur Steuerung der Bandlückenenergie der Halbleiterschichten dienen, die auf der Öffnung aufzuwachsen sind;
selektives Aufwachsen einer optischen Wellenleiterschicht (108, 208) auf der Nicht-Maskierungs-Streifenöffnung des Halbleitersubstrats durch eine Epitaxialwachstumstechnik unter Verwendung eines niedrigen Wachstumsdrucks von 33 mbar (25 Torr);
Erhöhen des Wachstumsdrucks oberhalb des niedrigen Wachstumsdrucks auf 200 mbar (150 Torr);
selektives Aufwachsen einer Mehrfach-Quantenwellstruktur-Schicht (15, 100, 210) auf der optischen Wellenleiterschicht durch die Epitaxialwachstumstechnik;
Verringern des Wachstumsdrucks unter den hohen Wachstumsdruck auf 33 mbar (25 Torr);
selektives Aufwachsen einer Deckschicht (12, 112, 212) auf der Mehrfach-Quantenwellstruktur-Schicht (15, 110, 210) durch die Epitaxialwachstumstechnik;
wobei der Aufwachsschritt der optischen Wellenleiterschicht, der Wachstumsdruck-Erhöhungsschritt, der Aufwachsschritt der Mehrfach-Quantenwellstruktur-Schicht, der Wachstumsdruck-Verringerungsschritt und der Aufwachsschritt der Deckschicht nacheinander in einem metallorganischen Dampfphasenepitaxieprozeß ausgeführt werden.

2. Verfahren nach Anspruch 1,
das des weiteren den Schritt umfaßt:
Schaffen einer Elektroden-Struktur (118, 119) für eine Strominjektion oder Anlegung einer Spannung an die Mehrfach-Quantenwellstruktur-Schicht.

3. Verfahren nach Anspruch 1,
das des weiteren den Schritt umfaßt:
Schaffen eines optischen Modulatorbereichs (104), in dem eine Niederreflektionsschicht auf deren Facette gebildet ist, wobei die Facette des optischen Modulatorbereichs mit einem Fensterbereich (107) ausgestattet ist, in dem keine optische Wellenleiterstruktur ausgebildet ist, um so Licht zu streuen, das von der optischen Wellenleiterstruktur zu dem Niederreflektionsschicht geleitet wird.

4. Verfahren nach Anspruch 1,
bei dem die integrierte optische Halbleiterschaltung eine integrierte Lichtquelle ist, die einen optischen Modulator vom Feld-Absorptions-Typ und einen verteilten Rückkopplungslaser enthält, die in einer monolithischen Art einstückig gebildet sind.

5. Verfahren nach Anspruch 1,
bei dem die integrierte Photonenhalbleiterschaltung ein abstimmbarer Bragg-Reflektionslaser ist.

## Revendications

1. Méthode pour la fabrication d'un circuit optique intégré à semi-conducteur, comprenant les étapes consistant à :
réaliser un masque (14), empêchant la croissance, sur un substrat semi-conducteur (101), ledit masque empêchant la croissance étant formé avec une première partie d'une première largeur et une seconde partie d'une seconde largeur supérieure à ladite première largeur, lesdites première et seconde parties ayant une ouverture non-masquante, en forme de bande, de largeur constante s'étendant dans le sens longitudinal à travers ladite seconde partie jusque dans ladite première partie de sorte qu'entre l'extrémité de l'ouverture formée dans la première partie et le bord à l'extrémité longitudinale de la première partie, est formée une zone qui sert de région de fenêtre dudit circuit optique intégré à semi-conducteur, et de telle sorte que les largeurs différentes desdites première et seconde parties servent à commander l'énergie de la bande interdite des couches de semi-conducteur devant être formées par croissance sur l'ouverture ; former sélectivement par croissance une couche de guide d'ondes lumineuses (108, 208) sur ladite ouverture non-masquante, en forme de bande, dudit substrat semi-conducteur par une technique de croissance épitaxiale à l'aide d'une faible pression de croissance de 33 mbar (25 Torr) ;
augmenter la pression de croissance au-dessus de ladite faible pression de croissance à 200 mbar (150 Torr) ;
former sélectivement par croissance une couche à structure de puits quantiques multiples (15, 100, 210) sur ladite couche de guide d'ondes lumineuses par ladite technique de croissance épitaxiale ;
diminuer ladite pression de croissance au-dessous de ladite forte pression de croissance jusqu'à 33 mbar (25 Torr) ;
former sélectivement par croissance une couche de recouvrement (12, 112, 212) sur ladite couche à structure de puits quantiques multiples par ladite technique de croissance épitaxiale ;
dans laquelle ladite étape de croissance de la couche de guide d'ondes lumineuses, ladite étape d'augmentation de la pression de croissance, ladite étape de croissance de la couche à structure de puits quantiques multiples, ladite étape de diminution de la pression de croissance, et ladite étape de croissance de la couche de recouvrement sont successivement effectuées dans un procédé d'épitaxie en phase vapeur organométallique.

2. Méthode selon la revendication 1, comprenant en outre l'étape consistant à :
réaliser une structure d'électrode (118, 119) pour injecter un courant ou appliquer une tension à ladite couche à structure de puits quantiques multiples.

3. Méthode selon la revendication 1, comprenant en outre l'étape consistant à :
réaliser une zone de modulateur optique (104) dans laquelle une couche à faible réflexion est formée sur sa facette, la facette de la zone de modulateur optique étant munie d'une région de fenêtre (107) dans laquelle aucune structure de guide d'onde optique n'est formée de manière à disperser une lumière émise par la structure de guide d'onde optique sur la couche à faible réflexion.

4. Méthode selon la revendication 1, dans laquelle :
ledit circuit optique intégré à semi-conducteur est une source de lumière intégrée comprenant un type absorbeur de champ de modulateur optique et un laser à réaction répartie qui sont intégrés de façon monolithique.

5. Méthode selon la revendication 1, dans laquelle:
ledit circuit optique intégré à semi-conducteur est un laser accordable à réflexion de Bragg répartie.
